# EUROPÄISCHE PATENTANMELDUNG

(11) **EP 1 437 933 A2**
(43) Veröffentlichungstag der Anmeldung: **14.07.2004**
(21) Anmeldenummer: 03104419.1
(22) Anmeldetag: 27.11.2003
(51) Int. Cl.: H05K 13/04

(54) **Vorrichtung zum Bestücken von Substraten mit Bauelementen und Verfahren zum Kalibrieren einer solchen Vorrichtung**

(30) Priorität: 09.01.2003 DE 10300518
(71) Anmelder: SIEMENS AKTIENGESELLSCHAFT, 80333 München (DE)
(72) Erfinder: Barnowski, Frank, 81379, München (DE); Lanzl, Lorenz, 81927, München (DE); Ohnrich, Bernd, 81379, München (DE); Prüfer, Martin, 81379, München (DE); Wörl, Manfred, 82110, Germering (DE)

(57) **Zusammenfassung**

Zum Kalibrieren einer Vorrichtung zum Bestücken von Substraten mit Bauelementen wird vorgeschlagen, um einen Bestückbereich (4) herum Kalibriermarkierungen (11) anzuordnen, die mit einer am Bestückkopf (2) angeordneten Kamera (10) vermessen werden. Anhand der vermessenen Position der Kalibriermarkierungen (11) läßt sich ein Portalverzug (14) ermitteln. Dieser Portalverzug (14) wird während des Bestückprozesses kompensiert.

## Beschreibung

Die Erfindung bezieht sich auf ein Verfahren zum Kalibrieren einer Vorrichtung zum Bestücken von Substraten mit Bauelementen sowie eine Vorrichtung zum Bestücken von Substraten mit Bauelementen gemäß dem Oberbegriff des Patentanspruchs 7.

Beim Bestücken von Substraten mit Bauelementen wird in Zukunft die erreichbare Positioniergenauigkeit zunehmend an Bedeutung gewinnen. Die Positioniergenauigkeit hängt dabei von der Fertigungsgenauigkeit eines Bestückautomaten ab. Um Fertigungsungenauigkeiten auszugleichen, werden Kalibrierverfahren benutzt, mit Hilfe derer die Bestückautomaten individuell vermessen werden.

Aus WO 98/42171 ist dafür ein Verfahren und eine Vorrichtung zum Vermessen einer Einrichtung zur Herstellung von elektrischen Baugruppen bekannt, bei der eine Testplatte in einem Bestückautomaten mit Nachbildungen von Bauelementen bestückt wird. Die Nachbildungen weisen definierte Markierungen auf und die Testplatte ist in der Nähe der Markierungen mit lokalen Referenzmarken von hoher Lagegenauigkeit versehen. Eine als ortsauflösender Sensor dienende Leiterplattenkamera des Bestückautomaten wird anschließend sukzessive über die Markierungen und Referenzmarken verfahren. Dabei liegt jeweils eine Markierung und eine Referenzmarke im Tastfeld der Kamera. Da ein solches Kalibrierverfahren aufgrund der verwendeten besonders ausgestalteten Testplatten und Nachbildungen in der Regel eine zeitaufwendige Umrüstung des Bestückautomaten erfordert, wird eine solche Kalibrierung in der Regel nur nach der Inbetriebnahme der Maschine und in fest vorgesehenen Serviceabständen durchgeführt.

Aus WO 97/38567 ist ein Verfahren und eine Vorrichtung zum Bestücken von Substraten mit Bauelementen bekannt, bei der die Positioniergenauigkeit dadurch erhöht wird, daß an der Maschine ortsfest eine Referenzplatte angeordnet ist, die gleichzeitig von einer Bauelementekamera und einer Leiterplattenkamera aufgenommen wird. Durch die gleichzeitige Aufnahme der Referenzplatte kann der Abstand zwischen der Bauelementekamera und der Leiterplattenkamera genau ermittelt werden und für den weiteren Bestückvorgang berücksichtigt werden.

Bei den steigenden Anforderungen an die Bestückgenauigkeit spielt mittlerweile auch die Temperaturabhängigkeit der Bestückgenauigkeit eine Rolle. Dies führt bereits zu Forderungen nach einem "Warmfahren" des Bestückautomaten.

Bei Bestückautomaten, die einen Bestückkopf aufweisen, der in einem Portalsystem bewegt wird, hängt die Temperatur des Portals allerdings nicht nur von der Umgebungstemperatur, sondern auch von dem tatsächlich gefahrenen Weg der Portalachsen ab. Die Näherung, eine einmal warmgefahrene Maschine als konstant anzunehmen, ist mit steigenden Genauigkeitsanforderungen nicht mehr gültig. Es ist daher die Aufgabe der Erfindung, ein automatisches Verfahren sowie eine Vorrichtung zur Durchführung des Verfahrens anzugeben, welche zur Maschinenlaufzeit ohne manuellen Bedienereingriff automatisch einen temperaturbedingten Drift aufgrund von Temperatureinflüssen erkennen und kompensieren können.

Die Aufgabe wird erfindungsgemäß gelöst durch ein Verfahren mit den Merkmalen des Anspruchs 1 und eine Vorrichtung der eingangs genannten Art mit den kennzeichnenden Merkmalen des Anspruchs 7.

Dafür sind an im Bestückbereich eines Bestückautomaten an unterschiedlichen Positionen Kalibriermarkierungen angebracht, deren relative Lage zur Position einer Kamera bestimmt wird und deren bestimmte relative Lage für den weiteren Bestückvorgang berücksichtigt wird. Mit einer solchen Referenzmessung wird die Maschine auf ihre Genauigkeit hin überprüft. Damit kann neben einem globalen Drift der Maschine auch die Portalverformung vermessen werden.

In der vorteilhaften Ausgestaltung des Verfahrens nach Anspruch 2 wird die Temperatur der Umgebung gemessen und in Abhängigkeit von der gemessenen Temperatur gegebenenfalls bei einem vorgegebenen Temperaturanstieg eine erneute Kalibrierung durchgeführt. Dadurch wird der Einfluß der Umgebungstemperatur auf die Bestückgenauigkeit vermindert.

Ebenfalls vorstellbar ist gemäß Anspruch 3, daß eine erneute Kalibrierung nach Ablauf einer vorgegebenen Zeit durchgeführt wird. Ein solches Verfahren hat den Vorteil, daß unabhängig von äußeren Einflüssen Portalverformungen, die sich im Lauf der Zeit ergeben, erkannt und kompensiert werden. Gemäß Anspruch 4 ist ein geeigneter Moment, um eine erneute Kalibrierung vorzunehmen, auch dann gegeben, wenn mit dem Bestückautomaten ein neues Bestückprogramm gefahren wird.

Gemäß Anspruch 5 wird das erfindungsgemäße Kalibrierungsverfahren in vorteilhafter Weise dann angewandt, wenn die Vorrichtung eine Stillstandszeit, beispielsweise durch leere Zuführeinheiten bei Vorgängermaschinen in einer Linie, durchläuft.

Gemäß Anspruch 6 ist vorgesehen, daß im Zuge einer erneuten Kalibrierung ebenfalls die zu bestückenden Substrate neu vermessen werden, um auch dort aufgetretene Abweichungen im Bestückablauf korrigieren zu können.

Besonders gut läßt sich der Portalverzug in einem x-y-Positioniersystem ermitteln, wenn gemäß Anspruch 8 die Kalibriermarken entlang einer der beiden ausgezeichneten Richtun gen des XY-Positioniersystems angeordnet sind, da in diesen Richtungen im allgemeinen auch die Portalachsen liegen.

Gemäß Anspruch 9 sollten die Kalibriermarkierungen am Rand des Bestückbereichs angeordnet sein, damit das Portal in der Gegend vermessen wird, in der auch die Bestückung stattfindet.

Ein geeigneter Platz für die Anbringung der Kalibiermarken ist gemäß Anspruch 10 parallel zu oder auf einer Transportvorrichtung für die Substrate gegeben.

Damit der ordnungsgemäße Bestückablauf durch die Kalibriermarkierungen nicht gestört wird, ist es gemäß Anspruch 11 vorgesehen, daß die Kalibriermarkierungen außerhalb von Transportwangen der Transportvorrichtung angeordnet sind.

Andererseits ist es auch denkbar, daß gemäß Anspruch 12 die Kalibriermarkierungen innerhalb der Transportwangen der Transportvorrichtung angeordnet sind, und während des Betriebs der Transportvorrichtung mittels eines Klappmechanismus aus der Transportvorrichtung versenkbar oder ausklappbar sind.

Für eine optimale Erkennung der Kalibriermarkierungen durch die Kamera am Bestückkopf sollten die Kalibriermarkierungen gemäß Anspruch 13 in derselben Höhe wie die Oberfläche des zu bestückenden Substrats angeordnet sein.

Eine geringe Temperaturabhängigkeit der Position der Kalibriermarkierungen wird durch die Verwendung eines temperaturbeständigen Werkstoffs wie beispielsweise Keramik gemäß Anspruch 14 erreicht.

Eine besonders gute Erkennung der Kalibriermarkierungen ist gemäß Anspruch 16 dadurch gegeben, daß die Kalibriermarkierungen auf einem Glasstreifen aufgebracht sind. Alternativ ist auch die Verwendung von einzelnen Marken oder eingelassenen Pins gemäß Anspruch 15 denkbar.

In vorteilhafter Weise ist gemäß Anspruch 17 vorgesehen, daß bei den Kalibriermarkierungen eine weitere Vorrichtung zur Ablage weiterer Kalibrierwerkzeuge - zum Beispiel der erwähnten Nachbildungen von Bauteilen - vorgesehen ist.

Anhand der Figuren der Zeichnung wird die Erfindung an einem Ausführungsbeispiel näher erläutert.

Dabei zeigen
Figur 1 eine schematische Draufsicht auf eine Vorrichtung zum Bestücken von Substraten mit Bauelementen, die mit zwei Portalen ausgestattet ist,
Figur 2 eine schematische Draufsicht auf eine Vorrichtung zum Bestücken von Substraten mit Bauelementen, in die schematisch ein Portalverzug eingezeichnet ist,
Figur 3a eine Variante von angebrachten Kalibriermarkierungen mit reduzierter Kalibriermarkenanzahl und
Figur 3b eine Variante von angebrachten Kalibriermarkierungen mit einer zusätzlichen Kalibrierteiltasche.

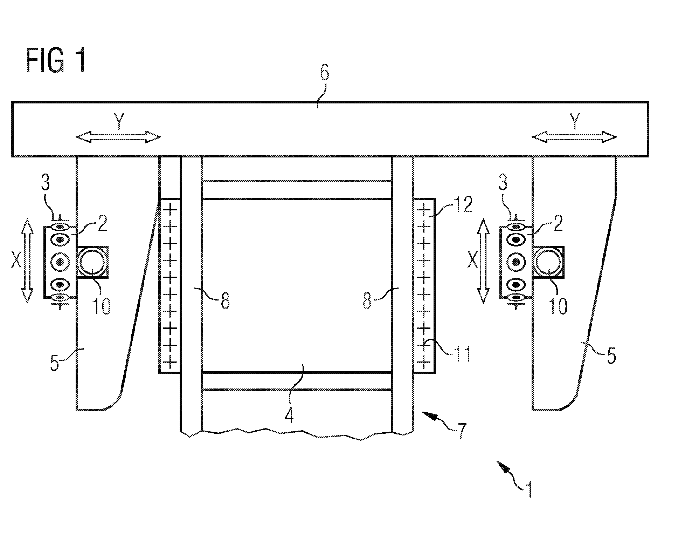

In Figur 1 ist schematisch eine Vorrichtung zum Bestücken von Substraten mit Bauelementen, ein Bestückautomat 1, dargestellt, der zwei Bestückköpfe 2 aufweist. Die Bestückköpfe 2 weisen eine Anzahl von Saugpipetten 3 auf, mit deren Hilfe die Bauelemente aus nicht dargestellten Zuführeinheiten entnommen werden und im Bestückbereich 4 auf dort befindliche Substrate aufgebracht werden. Dazu sind die Bestückköpfe 2 in der dargestellten X-Richtung beweglich an einem Portal 5 angebracht, wobei die Portale 5 wiederum beweglich in der dargestellten Y-Richtung an einem Ausleger 6, der fest mit dem festen Ständer der Maschine verbunden ist, angeordnet sind. Mit Hilfe einer Transportvorrichtung 7 werden Substrate, beispielsweise Leiterplatten, aus einem Magazin entnommen und in den Bestückbereich 4 und aus dem Bestückbereich 4 nach er folgter Bestückung wieder heraus gefahren. Dargestellt sind ebenfalls Transportwangen 8 als Ränder der Transportvorrichtung 7. Die Leiterplatten weisen dabei Markierungen auf, die mit an den Bestückköpfen 2 angeordneten Kameras 10 aufgenommen werden und deren Position und ggf. auch ein Leiterplattenverzug aus der Aufnahme in einer nicht dargestellten Steuereinrichtung ermittelt wird. Diese Position und der Leiterplattenverzug werden in der Steuereinrichtung beim Bestückvorgang insoweit berücksichtigt, daß Verzerrungen der Leiterplatten beim Positionieren in XY-Richtung kompensiert werden.

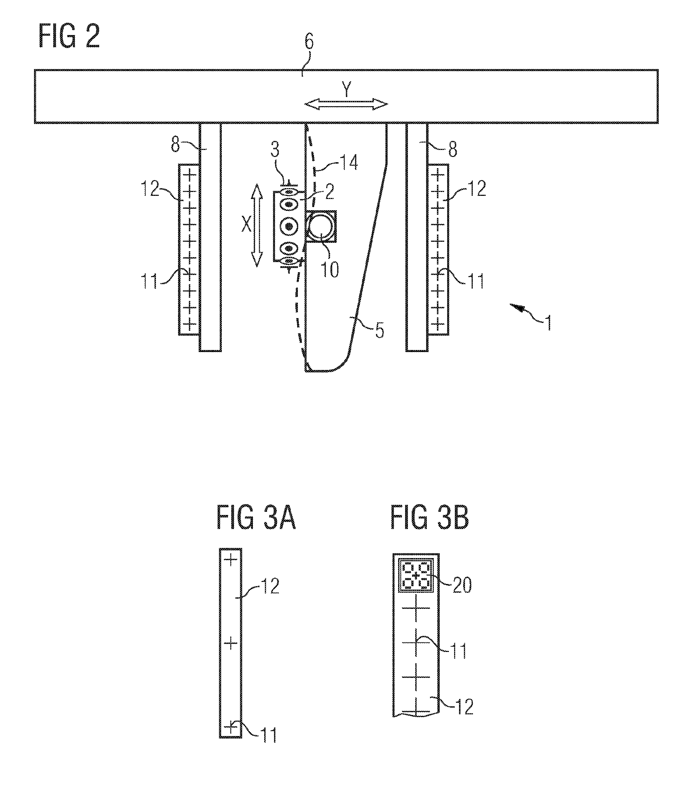

In Figur 2 ist durch die gestrichelte Linie 14 schematisch ein Portalverzug dargestellt, der aufgrund von am Portal auftretenden unterschiedlichen Temperaturen hervorgerufen werden kann. Besonders bei Portalen aus karbonfaserverstärkten Kunststoffen (CFK) wird aufgrund der geringen Wärmeleitfähigkeit von CFK die eingebrachte Wärme nicht abgeleitet, sondern führt zu einer lokalen Erwärmung. Die Orte der lokalen Erwärmung hängen dabei vom Bestückprogramm ab. Falls die Linearführungen und die Magnetplatten eines Linearmotors, der den Bestückkopf 2 entlang des Portals 5 bewegt, seitlich am Portal 5 befestigt sind, wird jede Verbiegung des Portals 5 aufgrund der unterschiedlichen Wärmeausdehnungskoeffizienten direkt in Y-Richtung als Positionierfehler sichtbar.

Daher sind am Rand des Bestückbereiches eine Mehrzahl von Kalibriermarkierungen 11 angeordnet. Diese Kalibriermarkierungen 11 befinden sich an einer oder mehreren Positionen des Ständers eines Bestückautomaten 1, in Figur 1 und 2 dargestellt durch eine Reihe von Kalibriermarkierungen 11 entlang der Transportvorrichtung 7, anhand derer zusätzlich zu einem globalen Drift auch die Portalverformung vermessen wird. Die Kalibriermarkierungen 11 sind dabei in derselben Höhe vorgesehen, wie die zu bestückende Leiterplatte und werden daher bevorzugt außerhalb der Transportwangen 8 der Transportvorrichtung 7 angeordnet.

Bei Bestückautomaten, bei denen die Positionierung durch einen gegenüber dem Ständer in einer Richtung beweglichen Leiterplatten-Shuttle und durch einen in einer im wesentlichen senkrechten Richtung dazu beweglichen Bestückkopf werden die Kalibriermarkierungen in bevorzugter Weise am Leiterplatten-Shuttle angebracht.

Zusammen mit dem Vermessen der Markierungen einer Leiterplatte werden nun auch die Kalibriermarkierungen 11 angefahren und die Vermessungsergebnisse als Referenz abgespeichert. Eine erneute Kontrollmessung wird immer dann durchgeführt, wenn sich Anzeichen ergeben, daß sich die Maschine zur Laufzeit verändert haben könnte. Beispiele dafür sind die Veränderungen der Temperatur um eine bestimmte vorgegebene Temperaturdifferenz, der Ablauf einer maximal vorgegebenen Zeitdifferenz oder die Änderung eines Bestückprogramms. Zusätzlich sind Stillstandszeiten, die zufällig auftreten (beispielsweise durch leere Zuführeinheiten bei in der Linie vorher angeordneten Bestückautomaten) dadurch zu nutzen, daß eine erneute Kalibriermessung durchgeführt wird und der Zähler für die Maximalzeit wieder zurückgesetzt wird.

Als Ausführung der Kalibriermarkierungen sind verschiedene Versionen denkbar. Zum einen können die Markierungen beispielsweise als Glasstreifen 12 direkt neben den Transportwangen 8 der Transportvorrichtung 7, wie es in Figur 1 und 2 dargestellt ist, angeordnet sein. Es ist aber auch eine Anordnung innerhalb der Transportwangen 8 denkbar, wenn zusätzlich ein Klapp- oder Hubmechanismus vorgesehen ist, um die Kalibriermarkierungen 11 während des Transports der Substrate aus dem Transportbereich auszuklappen oder herauszufahren.

Außer Glasstreifen sind auch andere temperaturbeständige Materialien wie beispielsweise Keramik als Träger für die Kalibriermarkierungen einsetzbar. Als Kalibriermarkierungen eignen sich ebenfalls in einen Werkstoff eingelassene Pins oder in einen Werkstoff an genauer Position gebohrte Löcher.

Die Anzahl der Markierungen kann dabei variieren. Gegebenenfalls reichen dafür, wie in Figur 3a dargestellt, bereits zwei bis drei Markierungen. Je mehr Markierungen über der Länge aufgebracht werden, um so genauer ist der Verlauf des Portalverzuges ermittelbar. In einer weiteren Ausgestaltung gemäß Figur 3b kann es sinnvoll sein, den Bereich der Kalibriermarkierungen auch für die Ablage weiterer Kalibrierwerkzeuge wie Nachbildungen 20 zu verwenden, mit denen eine Testplatte bestückt werden kann.

Als Anordnungsort kommen grundsätzlich alle vier Kanten des Bestückbereichs 4 in Frage. Unter der Annahme, daß der Verzug des Portals 5 größer ist als der des Ständers, wird eine Orientierung in X-Richtung bevorzugt.

Durch das erfindungsgemäße Verfahren und die erfindungsgemäße Vorrichtung wird die Temperaturabhängigkeit des Portalsystems vermessen und kompensiert. Dadurch läßt sich die Positioniergenauigkeit steigern, indem ein vollautomatischer Ablauf zur Vermessung ohne Bedienereingriff angeboten wird.

## Patentansprüche

1. Verfahren zum Kalibrieren einer Vorrichtung zum Bestücken von Substraten mit Bauelementen, die einen Ständer, ein Positioniersystem, einen Bestückkopf (2), mit dem Bauelemente aus einer Zuführeinheit entnommen und auf ein Substrat, welches sich in einem Bestückbereich der Vorrichtung befindet, abgesetzt werden und eine Kamera (10) zum Aufnehmen von Substratmarkierungen aufweist, wobei
- mit der Kamera (10) eine Mehrzahl von am Bestückbereich an unterschiedlichen Positionen angebrachten Kalibriermarkierungen (11) aufgenommen wird,
- die relative Lage der Kalibriermarkierungen (11) zur Position der Kamera am Positioniersystem bestimmt wird und
- die bestimmte relative Lage für den weiteren Bestückvorgang berücksichtigt wird.

2. Verfahren zum Kalibrieren einer Vorrichtung zum Bestücken von Substraten mit Bauelementen nach Anspruch 1,
**dadurch gekennzeichnet,**
**dass** die Temperatur der Umgebung gemessen wird und
**dass** bei einem gemessenen Temperaturanstieg um eine vorgegebene Temperaturdifferenz eine neue Kalibrierung durchgeführt wird.

3. Verfahren zum Kalibrieren einer Vorrichtung zum Bestücken von Substraten mit Bauelementen nach einem der Ansprüche 1 oder 2,
**dadurch gekennzeichnet,**
**dass** nach Ablauf einer vorgegebenen Zeit eine erneute Kalibrierung durchgeführt wird.

4. Verfahren zum Kalibrieren einer Vorrichtung zum Bestücken von Substraten mit Bauelementen nach einem der Ansprüche 1, 2 oder 3,
**dadurch gekennzeichnet,**
**dass** nach Änderung eines Bestückprogramms eine erneute Kalibrierung durchgeführt wird.

5. Verfahren zum Kalibrieren einer Vorrichtung zum Bestücken von Substraten mit Bauelementen nach einem der Ansprüche 1 bis 4,
**dadurch gekennzeichnet,**
**dass** eine erneute Kalibrierung während Stillstandzeiten der Vorrichtung durchgeführt wird.

6. Verfahren zum Kalibrieren einer Vorrichtung zum Bestücken von Substraten mit Bauelementen nach einem der Ansprüche 1 bis 5,
**dadurch gekennzeichnet,**
**dass** nach einer erneuten Kalibrierung auch die Substratmarkierungen neu vermessen werden.

7. Vorrichtung zum Bestücken von Substraten mit Bauelementen insbesondere zur Durchführung eines Verfahren nach den Ansprüchen 1 bis 6,
mit einem Ständer, einem Bestückkopf, mit dem Bauelemente aus einer Zuführeinheit entnommen und auf ein Substrat, welches sich in einem Bestückbereich der Vorrichtung befindet, abgesetzt werden, einem Positioniersystem, welches derartig ausgestaltet ist, dass es den Bestückkopf (2) in x-y-Richtung relativ zum Substrat bewegen kann, und einer Kamera (10) zum Aufnehmen von Substratmarkierungen,
**dadurch gekennzeichnet,**
**dass** an mehreren Positionen an der Vorrichtung im erreichbaren Gesichtsfeld der Kamera (10) Kalibriermarkierungen (11) angeordnet sind.

8. Vorrichtung zum Bestücken von Substraten mit Bauelementen nach Anspruch 7,
**dadurch gekennzeichnet,**
**dass** das Positioniersystem als x-y-Positioniersystem mit einem Portal (5) ausgebildet ist, an dem der Bestückkopf (2) befestigt ist, dass die Kamera (10) am Bestückkopf befestigt ist und dass die Kalibriermarkierungen (11) entlang einer der beiden ausgezeichneten Richtungen (x oder y) des x-y-Positioniersystems ortsfest am Ständer angeordnet sind.

9. Vorrichtung zum Bestücken von Substraten mit Bauelementen nach einem der Ansprüche 7 oder 8,
**dadurch gekennzeichnet,**
**dass** die Kalibriermarkierungen (11) am Rand des Bestückbereichs (4) angeordnet sind.

10. Vorrichtung zum Bestücken von Substraten mit Bauelementen nach einem der Ansprüche 7, 8 oder 9,
**dadurch gekennzeichnet,**
**dass** die Kalibriermarkierungen (11) entlang einer Transportvorrichtung (7) für die Substrate angeordnet sind.

11. Vorrichtung zum Bestücken von Substraten mit Bauelementen nach Anspruch 10,
**dadurch gekennzeichnet,**
**dass** die Kalibriermarkierungen (11) außerhalb von Transportwangen (8) der Transportvorrichtung (7) angeordnet sind.

12. Vorrichtung zum Bestücken von Substraten mit Bauelementen nach einem der Ansprüche 7 bis 10,
**dadurch gekennzeichnet,**
**dass** die Kalibriermarkierungen (11) innerhalb von Transportwangen (8) der Transportvorrichtung (7) angeordnet sind und während des Betriebs der Transportvorrichtung (7) mittels eines Klapp- oder Hubmechanismus in einen Bereich innerhalb oder außerhalb der Transportwangen (8) ausklappbar oder ausfahrbar sind.

13. Vorrichtung zum Bestücken von Substraten mit Bauelementen nach einem der Ansprüche 7 bis 12,
**dadurch gekennzeichnet,**
**dass** die Kalibriermarkierungen (11) in derselben Höhe wie die Oberfläche des Substrates angeordnet sind.

14. Vorrichtung zum Bestücken von Substraten mit Bauelementen nach einem der Ansprüche 7 bis 13,
**dadurch gekennzeichnet,**
**dass** die Kalibriermarkierungen (11) auf einen temperaturbeständigen Werkstoff (12) aufgebracht sind.

15. Vorrichtung zum Bestücken von Substraten mit Bauelementen nach einem der Ansprüche 7 bis 13,
**dadurch gekennzeichnet,**
**dass** die Kalibriermarkierungen (11) als in einen Werkstoff eingelassene Pins ausgebildet sind.

16. Vorrichtung zum Bestücken von Substraten mit Bauelementen nach einem der Ansprüche 7 bis 13,
**dadurch gekennzeichnet,**
**dass** die Kalibriermarkierungen (11) auf einen Glasstreifen (12) aufgebracht sind.

17. Vorrichtung zum Bestücken von Substraten mit Bauelementen nach einem der Ansprüche 7 bis 16,
**dadurch gekennzeichnet,**
**dass** neben den Kalibriermarkierungen eine Vorrichtung zur Ablage weiterer Kalibrierwerkzeuge vorgesehen ist.
